(19) Europäisches Patentamt
European Patent Office
Office européen des brevets

(11) **EP 4 010 932 B1**

(12) **FASCICULE DE BREVET EUROPEEN**

(45) Date de publication et mention de la délivrance du brevet:
**09.08.2023 Bulletin 2023/32**

(21) Numéro de dépôt: **20742271.8**

(22) Date de dépôt: **22.07.2020**

(51) Classification Internationale des Brevets (IPC):
**H01L 31/101** $^{(2006.01)}$ **H01Q 23/00** $^{(2006.01)}$
**H01Q 9/16** $^{(2006.01)}$

(52) Classification Coopérative des Brevets (CPC):
**H01L 31/101;** H01Q 9/16; H01Q 23/00

(86) Numéro de dépôt international:
**PCT/EP2020/070651**

(87) Numéro de publication internationale:
**WO 2021/023511 (11.02.2021 Gazette 2021/06)**

(54) **DISPOSITIF OPTOÉLECTRONIQUE PLANAIRE DE GÉNÉRATION D'UN SIGNAL HYPERFRÉQUENCE**

PLANARE OPTOELEKTRONISCHE VORRICHTUNG ZUR ERZEUGUNG EINES MIKROWELLENSIGNALS

PLANAR OPTOELECTRONIC DEVICE FOR GENERATING A MICROWAVE SIGNAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.08.2019 FR 1908847**

(43) Date de publication de la demande:
**15.06.2022 Bulletin 2022/24**

(73) Titulaires:
• **THALES**
**92400 Courbevoie (FR)**
• **Commissariat à l'Energie Atomique et aux Energies Alternatives**
**75015 Paris (FR)**

(72) Inventeurs:
• **VAN DIJK, Frédéric**
**91767 Palaiseau Cedex (FR)**
• **JANKOWSKI, Andrzej**
**91767 Palaiseau Cedex (FR)**

(74) Mandataire: **Atout PI Laplace**
**Immeuble "Visium"**
**22, avenue Aristide Briand**
**94117 Arcueil Cedex (FR)**

(56) Documents cités:
**GB-A- 2 324 911    US-A1- 2014 010 547**
**US-A1- 2014 231 627**

• **N. SHIMIZU ET AL: "Photodiode-integrated microstrip antenna array for subterahertz radiation", IEEE PHOTONICS TECHNOLOGY LETTERS., vol. 18, no. 6, 1 mars 2006 (2006-03-01), pages 743-745, XP055411789, US ISSN: 1041-1135, DOI: 10.1109/LPT.2006.871131 cité dans la demande**

EP 4 010 932 B1

## Description

### DOMAINE DE L'INVENTION

L'invention s'inscrit dans le domaine des dispositifs émetteurs de puissance hyperfréquence (RF), et plus précisément des dispositifs optoélectroniques à base de photodétecteurs typiquement semiconducteurs. Le dispositif selon l'invention est particulièrement adapté pour l'émission d'ondes de forte puissance et hautes fréquences, comprises entre 30 GHz et 1 THz. Ces dispositifs trouvent à s'intégrer dans des systèmes radar haute fréquence (typiquement >60GHz), des systèmes de transmission de données très haut débit (5G, transmission de données sans contact), des systèmes de spectroscopie, de détection.

### ETAT DE LA TECHNIQUE

Pour les systèmes RADAR et pour les transmissions de données, une des tendances est d'augmenter la fréquence des signaux dans la gamme millimétrique (30-300 GHz) voir jusqu'à 1THz dans le futur. Dans la partie haute de cette gamme, il est difficile de générer beaucoup de puissance et de transporter les signaux. Les solutions optiques ont de nombreux avantages comme la possibilité de transporter les signaux pratiquement sans pertes sur fibre optique, d'accorder largement la fréquence générée et de contrôler la phase du signal généré. Cependant les puissances générées sont souvent insuffisantes. En effet par voie optique il est facile d'amplifier les signaux, ce qui devrait permettre des puissances très élevées. Cependant des photodétecteurs ayant une tenue à la puissance suffisante n'existent pas à ce jour. Les photodiodes sont limitées par le compromis qui fait que :

- pour augmenter la tenue à la puissance il faut augmenter les dimensions et l'épaisseur des couches, alors que
- pour avoir une réponse en fréquence satisfaisante il faut réduire les dimensions et l'épaisseur des couches.

Ces composants ont une tenue aux fortes puissances optiques incidentes limitée, notamment à cause de phénomènes thermo-électriques.

Jusqu'à présent pour augmenter la puissance maximale que peut générer une photodiode on joue sur les dimensions géométriques du composant et sur les épaisseurs des couches qui le constituent. Cependant cette approche se trouve limitée quand on veut avoir un signal élevé à haute fréquence. En effet on souhaitera avoir de grandes dimensions pour la génération de fortes puissances mais pour générer des hautes fréquences on doit limiter les effets de capacité parasite que l'on a avec de grandes dimensions.

Ainsi les photodiodes à semiconducteurs sont une solution prometteuse pour générer des signaux à très haute fréquence, jusqu'au térahertz, avec un bon contrôle de la fréquence et de la phase, mais leur application butte sur leur tenue à la puissance à haute fréquence.

Des solutions utilisant un réseau de photodiodes arrangées en ligne et reliées par une ligne coplanaire permettent de réduire la contrainte en répartissant la puissance. Cependant dans ce cas la moitié de la puissance est perdue dans la charge placée à l'une des extrémités de la ligne.

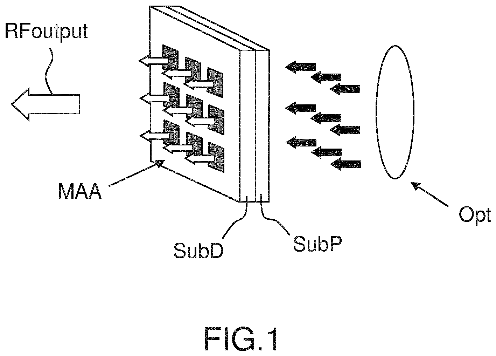

Des solutions utilisant des réseaux de photodiodes intégrées avec des antennes ont également été proposées. Par exemple le document « Photodiode-Integrated Microstrip Antenna Array for Subterahertz Radiation » de Shimizu et al (IEEE Photonics technology letters, Vol 18, n°6, 15 mars 2006) décrit un système matriciel de N photodiodes planaires indépendantes illustré figure 1 comprenant une source (non représentée) couplée à un système optique Opt complexe permettant d'éclairer individuellement chaque photodiode de la matrice déposée sur un substrat SubP en InP. Chaque photodiode est couplée à une antenne de type microstrip déposée sur un substrat diélectrique SubD pour former une matrice MAA (« Microstrip Array Antenna » en anglais). L'onde RFoutput émise par le système, d'environ 1 mW, est la somme cohérente des émissions des N antennes individuelles. Chaque antenne individuelle a une dimension autour de 230 $\mu$m qui correspond à la demi-longueur d'onde associée à la fréquence de résonance de 300 GHz.

Un inconvénient de cette solution est que la lumière éclaire toute la surface du substrat et donc qu'une grande partie de la puissance optique incidente n'est pas photodétectée, le rendement global est très faible. En outre du fait de la taille de chaque antenne individuelle la taille globale de la matrice d'antenne est importante.

US 2014/231627 A1 décrit un dispositif optoélectronique pour générer et rayonner un signal térahertz comprenant un guide diviseur et un ensemble de photodiodes chacune étant reliée à un élément métallique formant une antenne, le guide diviseur étant configuré pour injecter un faisceau élémentaire dans une photodiode associée.

Un but de la présente invention est de remédier aux inconvénients précités en proposant un dispositif optoélectronique de génération et de rayonnement d'un signal RF haute fréquence et de forte puissance peu coûteux et peu encombrant.

### DESCRIPTION DE L'INVENTION

La présente invention a pour objet un dispositif optoélectronique pour générer et rayonner un signal électromagnétique présentant au moins une fréquence centrale F0 comprise entre 30GHz et 1THz comprenant :

- un guide diviseur configuré pour diviser, dans un plan XY, un faisceau optique d'entrée porteur dudit signal électromagnétique en n faisceaux élémentaires,

- un ensemble de n photodiodes comprenant un matériau semi-conducteur disposées sur au moins une ligne, les photodiodes d'une ligne étant reliées électriquement entre elles en série par un ensemble métallique planaire comprenant une pluralité d'éléments métalliques, une photodiode étant reliée à la suivante par un élément métallique et étant disposée entre deux éléments métalliques,

- le guide diviseur étant en outre configuré pour injecter un faisceau élémentaire dans une photodiode associée et de sorte qu'un retard optique relatif entre deux faisceaux élémentaires à l'arrivée sur la photodiode associée est inférieur à une période dudit signal électromagnétique,

l'ensemble métallique et l'ensemble de photodiodes formant une antenne apte à rayonner ledit signal électromagnétique, chaque photodiode constituant une entrée électrique de l'antenne, l'antenne présentant une longueur égale à un multiple de la moitié d'une longueur d'onde centrale calculée à partir de la fréquence centrale.

Préférentiellement le guide diviseur comprend n guides élémentaires pour propager les n faisceaux élémentaires jusqu'aux photodiodes associées.

Selon un mode de réalisation le guide diviseur est un guide en étoile.

Selon un autre mode de réalisation le guide diviseur est un guide par interférence.

Préférentiellement la longueur de l'antenne est égale à la moitié de la longueur d'onde centrale.

Selon une variante les éléments métalliques présentent une forme de ligne, l'antenne étant alors de type quasi-dipôle.

Selon une autre variante l'ensemble métallique est configuré de sorte que l'antenne est de type log-périodique.

Selon un mode de réalisation l'ensemble métallique est polarisé via une tension continue appliquée aux deux extrémités.

Selon un mode de réalisation les photodiodes sont disposées en matrice selon une pluralité de lignes parallèles reliées électriquement entre elles par les extrémités.

Selon un mode de réalisation le dispositif selon l'invention comprend un substrat sur lequel est disposé le guide diviseur, chaque photodiode comprenant une couche active disposée entre une première et une deuxième couche de contact, et étant couplée au guide élémentaire associé via la première couche de contact, un élément métallique disposé entre deux diodes successives reliant électriquement la première couche de contact d'une photodiode à la deuxième couche de contact de la photodiode suivante.

Préférentiellement le substrat est en InP, le guide diviseur comprend du GaInAs ou du GaInAsP et la couche active comprend du GaInAs ou du GaInAsP.

La description suivante présente plusieurs exemples de réalisation du dispositif de l'invention : ces exemples sont non limitatifs de la portée de l'invention. Ces exemples de réalisation présentent à la fois les caractéristiques essentielles de l'invention ainsi que des caractéristiques additionnelles liées aux modes de réalisation considérés.

L'invention sera mieux comprise et d'autres caractéristiques, buts et avantages de celle-ci apparaîtront au cours de la description détaillée qui va suivre et en regard des dessins annexés donnés à titre d'exemples non limitatifs et sur lesquels :

[Fig 1] La figure 1 déjà citée illustre un dispositif de génération d'un signal RF avec des photodiodes couplées à des antennes selon l'état de l'art.

[Fig 2] La figure 2 illustre une antenne dipôle utilisant une photodiode comme entrée électrique.

[Fig 3] La figure 3 illustre un dispositif optoélectronique selon l'invention.

[Fig 4] La figure 4 illustre la variation de la demi-longueur d'onde en fonction de la fréquence RF émise pour une photodiode à base d'InP.

[Fig 5] La figure 5 illustre de manière schématique un dispositif selon l'invention sans compensation géométrique des trajets optiques.

[Fig 6] La figure 6 illustre une variante de l'invention dans laquelle l'ensemble métallique EM est configuré de sorte que l'antenne est de type log-périodique.

[Fig 7] La figure 7 illustre un dispositif selon l'invention dans lequel les photodiodes sont disposées en matrice selon une pluralité de lignes parallèles reliées électriquement entre elles par les extrémités.

[Fig 8] La figure 8 illustre un dispositif selon l'invention à base de photodiodes semiconductrices de type guide sur un substrat, avec un empilement de couches de différents matériaux pour former les guides d'onde optique ainsi que les photo-détecteurs. La figure 8a illustre la vue de dessus (plan XY) tandis que les figures 8b et 8c illustrent les vues de côté, respectivement selon le plan XZ et YZ.

**DESCRIPTION DETAILLEE DE L'INVENTION**

Afin de bien comprendre le fonctionnement du dispositif selon l'invention, le fonctionnement d'une antenne dipôle, destinée à émettre ou recevoir de l'énergie électromagnétique, est rappelé. De manière générale une antenne dipolaire est constituée de deux brins métalliques, alimentée électriquement en son milieu (entrée électrique) par une tension alternative en mode émission. Pour une entrée électrique « simple » lorsqu'en entrée on applique un courant alternatif de fréquence RF donnée, l'antenne rayonne un signal à cette même fréquence.

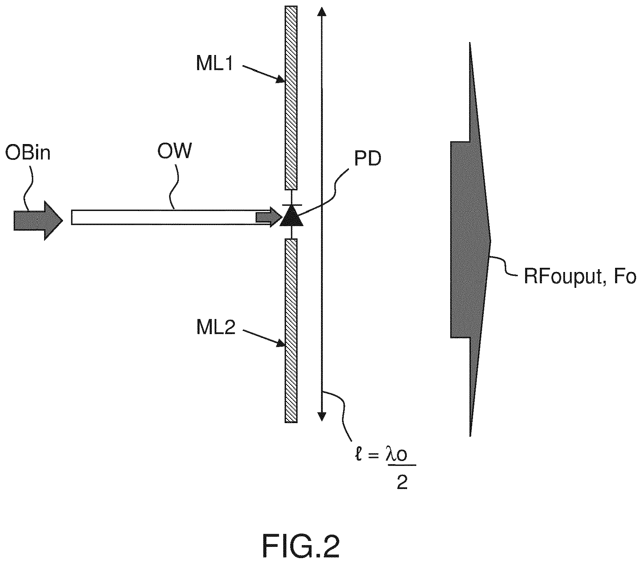

La figure 2 illustre une antenne dipôle utilisant une photodiode comme entrée électrique. La fréquence d'émission est dénommée F0. L'entrée électrique est constituée d'une photodiode PD alimentée par une onde optique OBin porteuse du signal RF de fréquence F0 qui est injectée dans PD via un guide d'onde OW. La longueur totale de la ligne métallique est dénommée / Pour obtenir une émission plus efficace préférentiellement on choisit / =k.λ0/2 avec k entier et λ0 longueur d'onde calculée à partir de F0 en tenant compte de la constante diélectrique relative $\varepsilon_r$ du substrat sur lequel est réalisé l'antenne, et plus particulièrement de son indice à la fréquence d'émission noté ne, égal à la racine carrée de $\varepsilon_r$:

[Math 1]

$$\lambda 0 = \frac{c}{\sqrt{\varepsilon_r} F_0}$$

La conséquence du dimensionnement de / est que l'émission sera résonnante pour une bande de fréquence autour de F0.

Une antenne dipôle telle qu'illustrée figure 2 alimentée par une photodiode présente l'inconvénient d'une émission avec une bande de fréquence très étroite autour de la fréquence de résonnance F0. Une solution connue est de remplacer la structure filaire des éléments ML1 et ML2 par une structure à base de triangles permettant de faire varier les dimensions de l'élément rayonnant et ainsi d'augmenter la bande de fréquence. Une telle antenne est dénommée antenne en noeud papillon («bowtie antenna» en anglais).

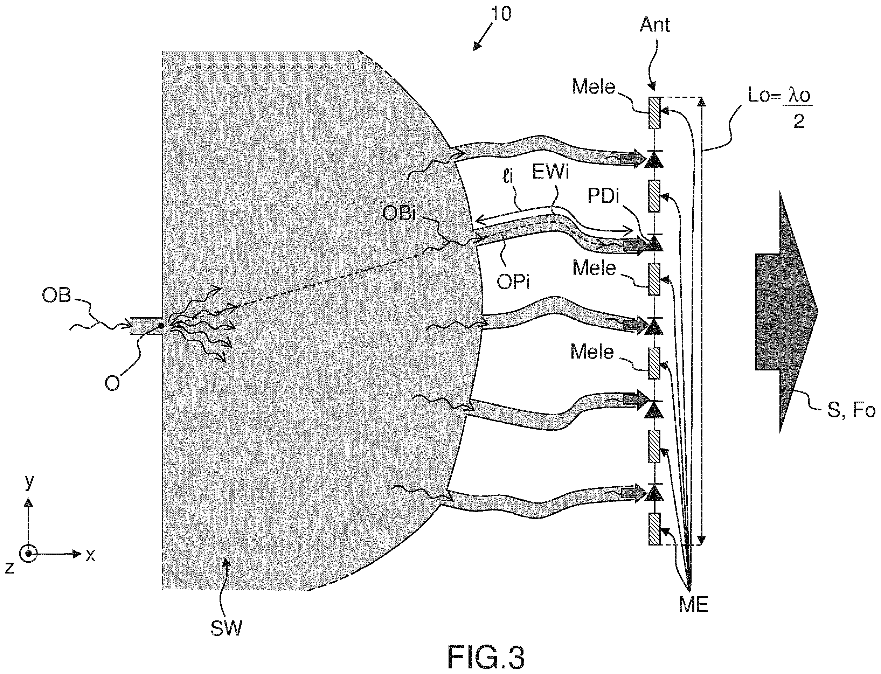

Le dispositif optoélectronique 10 selon l'invention pour générer et rayonner un signal électromagnétique S est illustré figure 3. Le signal S présente au moins une fréquence F0 dénommée fréquence centrale, comprise entre 30GHz et 1THz (signal communément dénommé RF). L'idée de base est d'associer n photodiodes semi-conductrices unitaires en série, injectées par une source optique dont la puissance est divisée en N sorties. Les n photodiodes sont interconnectées électriquement pour former une antenne qui émet la puissance RF.

Pour cela le dispositif selon l'invention comprend un guide diviseur SW configuré pour diviser, dans un plan XY, un faisceau optique d'entrée OB porteur du signal électromagnétique S en n faisceaux élémentaires. Il n'est pas nécessaire que les puissances respectives de chaque faisceau soient identiques.

Selon un mode de réalisation le guide SW est un guide optique passif. Selon un autre mode de réalisation le guide SW est actif, typiquement à base de couches semiconductrices avec du gain optique.

Le faisceau OB est couplé en entrée du guide SW. Selon un mode de réalisation le faisceau optique d'entrée OB est un signal optique typiquement modulé en amplitude avec le signal S. Selon un autre mode de réalisation le faisceau optique est constitué du battement hétérodyne entre une onde optique O1 (longueur d'onde λ1, fréquence optique f1) et une deuxième onde optique O2 (longueur d'onde λ2, fréquence optique f2). On dénomme battement hétérodyne la différence de fréquence optique f1-f2 à une fréquence hyper F. Les ondes optiques présentent typiquement une longueur d'onde comprise entre 400 nm et 10 μm, et préférentiellement entre 1.2μm et 7 μm. Les longueurs d'onde λ1 et λ2 sont très proches. Par exemple pour F = 1THz et λ1= 1.50 μm, on a λ2= 1.508 μm. Le signal OB est issu d'une source unique (non représentée).

Le dispositif 10 comprend également un ensemble de n photodiodes PDi, i indice allant de 1 à n, comprenant un matériau semi-conducteur, disposées sur au moins une ligne. Les photodiodes d'une ligne sont reliées électriquement entre elles en série par un ensemble métallique ME planaire comprenant une pluralité d'éléments métalliques Mele. Une photodiode est reliée à la suivante par un élément métallique et est disposée entre deux éléments métalliques. Typiquement pour n photodiodes on a n-1 éléments métalliques entre les photodiodes et deux éléments aux extrémités, soit n+1 éléments en tout.

Le guide diviseur SW est configuré pour injecter un faisceau élémentaire Obi dans une photodiode associée PDi et de sorte que les trajets optiques respectifs de chacun des faisceaux élémentaires jusqu'à la photodiode associée sont sensiblement identiques, c'est-à-dire que le retard optique relatif entre deux faisceaux élémentaires à l'arrivée sur la photodiode associée est faible par rapport à la période 1/F0 du signal de fréquence F0, c'est à dire au moins inférieur à 1/F0.

Préférentiellement le retard optique relatif entre deux faisceaux élémentaires à l'arrivée sur la photodiode associée est inférieur à 1/4.F0.

Comme illustré figure 3 on entend par trajet optique le trajet OPi qui commence au point de séparation O et se termine sur la photodiode PDi. Pour un guide diviseur constitué d'un matériau homogène, les trajets optiques sont identiques si les longueurs des trajets OPi sont identiques.

Préférentiellement le guide diviseur comprend n guides élémentaires EWi pour propager les n faisceaux élémentaires OBi jusqu'aux photodiodes associées.

L'égalité des trajets optiques peut également être obtenue en modifiant localement l'indice de réfraction des différents guides élémentaires.

Du fait de cette condition les faisceaux optiques arrivent sur les photodiodes associées avec un retard identique, ce qui a pour conséquence que les ondes RF générées par chacune des photodiodes sont en phase, permettant une superposition cohérente de ces ondes.

En dehors des pertes de couplage en entrée et des pertes de propagation dans le guide SW, on bénéficie du bon rendement électro-optique des photodiodes, avec une puissance démultipliée par le nombre de photodiodes.

La combinaison de l'ensemble métallique ME et de l'ensemble de photodiodes forme une antenne Ant unique apte à rayonner ledit signal électromagnétique S.

Chaque photodiode constitue une entrée électrique de l'antenne. L'antenne présente une longueur L0 correspondant à un multiple de la moitié d'une longueur d'onde centrale $\lambda$0 calculée à partir de la fréquence centrale F0 tel qu'expliqué plus haut. Le premier optimum pour L0 est une dimension sensiblement égale à $\lambda$0/2. Ainsi les éléments métalliques Mele présentent chacun une dimension très inférieure à $\lambda$0/2. La dimension globale de l'antenne Ant selon l'invention est beaucoup plus faible que celle décrite dans la publication de Shimizu précitée.

La connexion en série des photodiodes conduit à un comportement de l'antenne Ant différent de celui d'une juxtaposition d'antennes indépendantes comme décrit dans Shimizu. La continuité électrique fait que l'on a une seule antenne et non pas un ensemble de petites antennes sub-X/2 dipolaires dont l'efficacité de rayonnement est dégradée. En outre un seul émetteur réalise une émission RF sur un lobe unique.

Dans la variante la plus simple les éléments métalliques présentent une forme de ligne, l'antenne Ant étant alors la mise en série de petits dipôles dont la partie centrale est une photodiode. L'antenne est alors de type quasi-dipôle : les photodiodes sont combinées pour former un émetteur qui ressemble à un dipôle. Le comportement émissif est celui d'un dipôle car il n'y a qu'un seul élément rayonnant, alors que la structure comporte plusieurs entrées électriques et non pas une seule.

L'émission effectuée par une antenne unique de dimension sensiblement égale à $\lambda$0/2 ou à un multiple de $\lambda$0/2 permet d'obtenir une efficacité de rayonnement RF bien supérieure à celle d'une juxtaposition de n petits dipôles indépendants. En effet chaque petit dipôle présente une faible efficacité de rayonnement avec une impédance élevée et une faible directivité. Sans continuité électrique entre ces petits dipôles, leur juxtaposition présente un comportement qui ne peut pas se rapprocher de celui d'un dipôle ayant la dimension de la juxtaposition globale. Sans continuité électrique on conserve donc une faible efficacité de rayonnement.

La condition sur la longueur L0 permet l'obtention d'une émission à la fréquence souhaitée F0 avec une plus grande efficacité. Pour obtenir une antenne présentant la plus petite dimension possible on choisit L0=$\lambda$0/2.

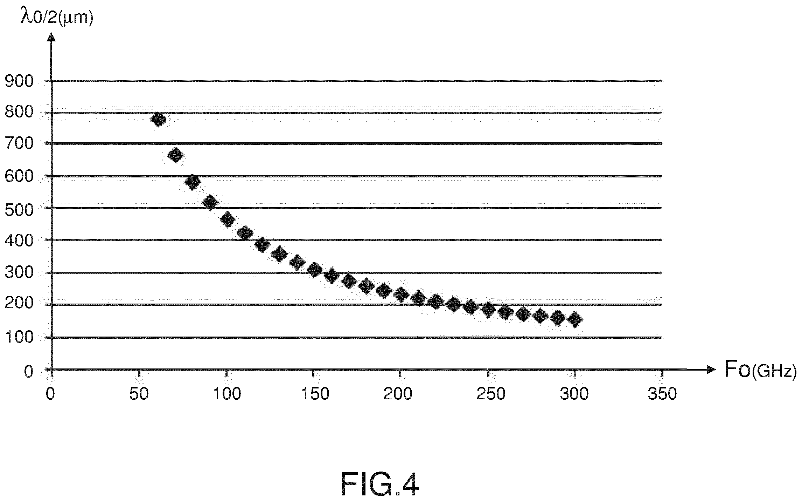

La figure 4 illustre la variation de la demi-longueur d'onde $\lambda$0/2 en fonction de la fréquence RF émise F0 dans le cas d'une couche active de la photodiode à base d'InP, matériau typique pour réaliser les photodiodes pour la RF. L'indice ne est sensiblement égal à 3.5.

Selon un mode de réalisation le guide diviseur est un guide optique passif en étoile ou « star coupler » en anglais.

Selon un autre mode de réalisation le guide diviseur est un guide/coupleur par interférence multimode. Ce type de coupleur utilise les interférences venant des réflexions sur les parois d'un guide large, multimode, pour diviser la puissance d'un faisceau optique incident. Pour cela les sorties du dispositif sont positionnées sur les nœuds des interférences spatiales générées. Ce type de diviseur permet une séparation bien équilibrée du faisceau vers les différentes sorties et présente une architecture compacte.

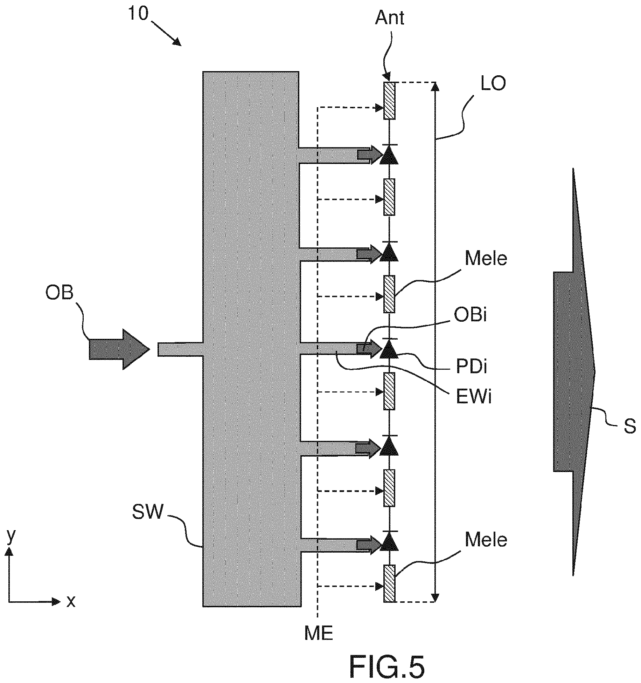

La figure 5 illustre de manière schématique un dispositif selon l'invention sans compensation géométrique des trajets optiques (c'est-à-dire égalisation de la longueur des trajets), cette compensation étant réalisée par exemple via une modification locale de l'indice de réfraction de chaque guide élémentaire EWi ou via l'utilisation d'un coupleur par interférence.

Les antennes de type dipôles ou quasi dipôle présentent l'inconvénient d'être très résonnantes ce qui limite la bande passante de ce type de solution.

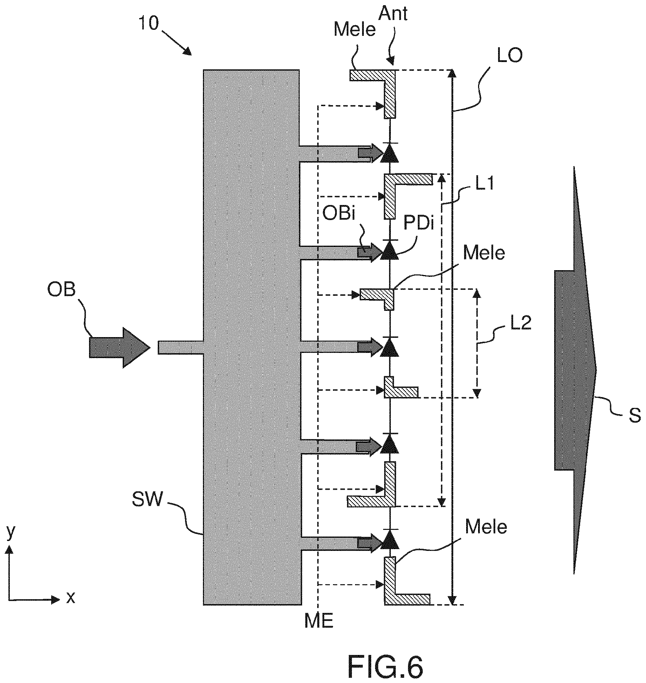

Selon une variante illustrée figure 6 l'ensemble métallique EM est configuré de sorte que l'antenne Ant est de type log-périodique. Les éléments métalliques présentent une forme et sont agencés pour former un design d'antenne log-périodique. Le principe de ce design est bien connu de l'homme de l'art. La géométrie des éléments Mele permet à l'antenne Ant d'émettre selon plusieurs fréquences associées à différentes longueurs notées L0, L1 et L2 sur la figure 6.

Selon un mode de réalisation le dispositif 10 fonctionne sans être polarisé électriquement, il fonctionne alors en mode photovoltaïque.

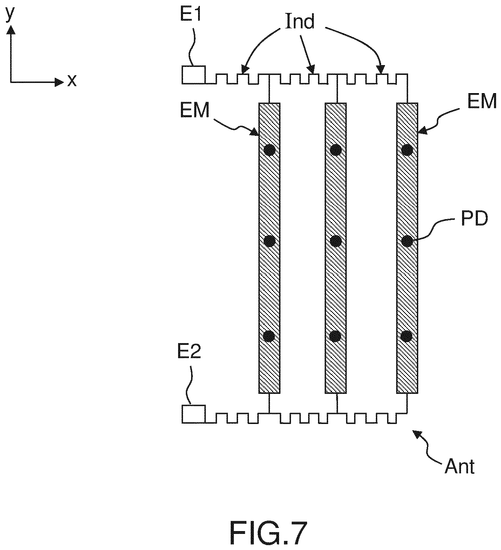

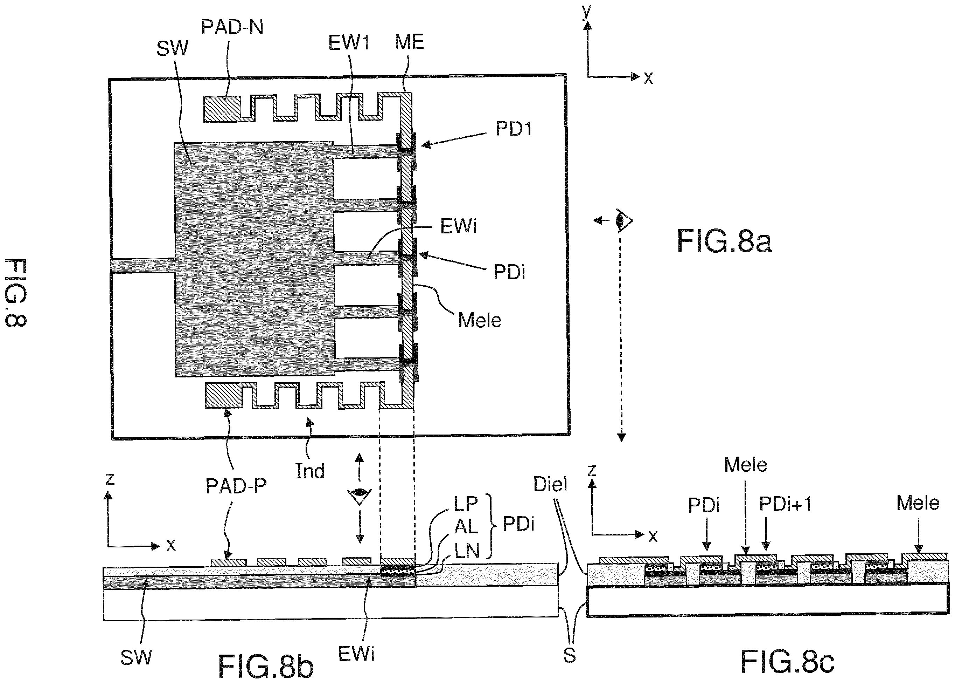

Selon un autre mode de réalisation l'ensemble métallique est polarisé via une tension continue appliquée aux deux extrémités. On dispose pour cela une électrode à chaque extrémité (voir plus loin figure 7: E1, E2 et figure 8:PAD-N et PAD-P) de la ligne formée par l'ensemble métallique, séparée de celui-ci par un élément (voir figures 7 et 8: Ind) qui empêche les fuites de l'onde haute fréquence, typiquement un élément de type self telle une inductance. Il est connu que la polarisation de l'antenne augmente la puissance émise en assurant un meilleur rendement de conversion de chaque photodiode.

Selon un mode de réalisation illustré figure 7 les photodiodes PD sont disposées en matrice selon une pluralité de lignes parallèles reliées électriquement entre elles par les extrémités. L'antenne Ant est alors constituée d'un ensemble d'éléments métalliques préférentiellement reliés entre eux avec un élément de type self pour éviter les fuites RF. Dans l'exemple de la figure 7 le dispositif est polarisé via les électrodes E1 et E2.

La figure 8 illustre un exemple de réalisation du dispositif selon l'invention. On utilise une technologie de réalisation de photodiodes de type guide sur un substrat, avec un empilement de couches de différents matériaux pour former les guides d'onde optique ainsi que les photo-détecteurs. La figure 8a illustre la vue de dessus (plan XY) tandis que les figures 8b et 8c illustrent les vues de côté, respectivement selon le plan XZ et YZ.

Le dispositif 10 illustré figure 8 comprend un substrat S sur lequel est disposé le guide diviseur SW. Chaque photodiode semi conductrice PDi comprend une couche active AL disposée entre une première couche de contact LN et une deuxième couche de contact LP et est typiquement couplée au guide élémentaire associé EWi via la première couche de contact LN, comme illustré figure 8b.

Un élément métallique Mele disposé entre deux diodes successives relie électriquement la première couche de contact LNi de la photodiode PDi à la deuxième couche de contact LPi+1 de la photodiode suivante PDi+1, comme illustré figure 8c.

Les deux éléments métalliques des extrémités sont chacun relié à une électrode, respectivement PAD-N et PAD-P, et entre l'électrode et l'élément métallique on dispose un composant inductif métallique Ind.

Selon un mode de réalisation le substrat est en InP, le guide diviseur comprend du GaInAs ou du GaInAsP et la couche active comprend du GaInAs ou du GaInAsP. La couche LN est par exemple en InP ou en GaInAsP, et la couche LP en InP, en GaInAs ou en GaInAsP.

## Revendications

1. Dispositif optoélectronique (10) pour générer et rayonner un signal (S) électromagnétique présentant au moins une fréquence centrale F0 comprise entre 30GHz et 1THz comprenant :

   - un guide diviseur (SW) configuré pour diviser, dans un plan XY, un faisceau optique d'entrée (OB) porteur dudit signal électromagnétique (S) en n faisceaux élémentaires (OBi),
   - un ensemble de n photodiodes (PDi) comprenant un matériau semi-conducteur disposées sur au moins une ligne, les photodiodes d'une ligne étant reliées électriquement entre elles en série par un ensemble métallique (ME) planaire comprenant une pluralité d'éléments métalliques (Mele), une photodiode étant reliée à la suivante par un élément métallique et étant disposée entre deux éléments métalliques,
   - le guide diviseur (SW) étant en outre configuré pour injecter un faisceau élémentaire dans une photodiode associée (PDi) et de sorte qu'un retard optique relatif entre deux faisceaux élémentaires à l'arrivée sur la photodiode associée est inférieur à une période dudit signal électromagnétique,
   - l'ensemble métallique (ME) et l'ensemble de photodiodes formant une antenne (Ant) apte à rayonner ledit signal électromagnétique (S), chaque photodiode constituant une entrée électrique de l'antenne, l'antenne présentant une longueur (L0) égale à un multiple de la moitié d'une longueur d'onde centrale (λ0) calculée à partir de la fréquence centrale (F0).

2. Dispositif selon la revendication 1 dans lequel le guide diviseur comprend n guides élémentaires (EWi) pour propager les n faisceaux élémentaires (OBi) jusqu'aux photodiodes associées.

3. Dispositif selon l'une des revendications précédentes dans lequel le guide diviseur est un guide en étoile.

4. Dispositif selon les revendications 1 ou 2 dans lequel le guide diviseur est un guide par interférence.

5. Dispositif selon l'une des revendications précédentes dans lequel la longueur de l'antenne est égale à la moitié de ladite longueur d'onde centrale.

6. Dispositif selon la revendication précédente dans lequel les éléments métalliques présentent une forme de ligne, l'antenne étant alors de type quasi-dipôle.

7. Dispositif selon l'une des revendications 1 à 5 dans lequel l'ensemble métallique est configuré de sorte que l'antenne est de type log-périodique.

8. Dispositif selon l'une des revendications précédentes dans lequel l'ensemble métallique est polarisé via une tension continue appliquée aux deux extrémités.

9. Dispositif selon l'une des revendications précédentes dans lequel les photodiodes sont disposées en matrice selon une pluralité de lignes parallèles reliées électriquement entre elles par les extrémités.

10. Dispositif selon l'une des revendications 2 à 9 comprenant un substrat (S) sur lequel est disposé le guide diviseur (SW), chaque photodiode comprenant une couche active (AL) disposée entre une première (LN) et une deuxième (LP) couche de contact et étant couplée au guide élémentaire associé via la première couche de contact, un élément métallique (Mele) disposé entre deux diodes successives reliant électriquement la première couche de contact (LNi) d'une photodiode (PDi) à la deuxième couche de contact (LPi+1) de la photodiode suivante (PDi+1).

11. Dispositif selon la revendication 10 dans lequel le substrat est en InP, le guide diviseur comprend du GaInAs ou du GaInAsP et la couche active comprend du GaInAs ou du GaInAsP.

## Patentansprüche

1. Optoelektronische Vorrichtung (10) zum Erzeugen und Abstrahlen eines elektromagnetischen Signals (S), das mindestens eine Mittenfrequenz F0 zwischen 30 GHz und 1 THz aufweist, Folgendes umfassend:

- einen Führungsteiler (SW), der so konfiguriert ist, dass er in einer XY-Ebene einen optischen Eingangsstrahl (OB), der das elektromagnetische Signal (S) trägt, in n Elementarstrahlen (OBi) teilt,
- einen Satz von n Fotodioden (PDi), die ein Halbleitermaterial umfassen und in mindestens einer Zeile angeordnet sind, wobei die Fotodioden einer Zeile elektrisch miteinander in Reihe durch eine planare Metallanordnung (ME) verbunden sind, die eine Vielzahl von Metallelementen (Mele) umfasst, wobei eine Fotodiode mit der nächsten durch ein Metallelement verbunden ist und zwischen zwei Metallelementen angeordnet ist,
- wobei der Führungsteiler (SW) ferner so konfiguriert ist, dass er einen Elementarstrahl in eine zugehörige Fotodiode (PDi) einspeist und so, dass eine relative optische Verzögerung zwischen zwei Elementarstrahlen beim Auftreffen auf die zugehörige Fotodiode kleiner als eine Periode des elektromagnetischen Signals ist,
- wobei die Metallanordnung (ME) und die Fotodiodenanordnung eine Antenne (Ant) bilden, die in der Lage ist, das elektromagnetische Signal (S) abzustrahlen, wobei jede Fotodiode einen elektrischen Eingang der Antenne bildet, wobei die Antenne eine Länge (L0) aufweist, die gleich einem Vielfachen der Hälfte einer Mittenwellenlänge (λ0) ist, die anhand der Mittenfrequenz (F0) berechnet wird.

2. Vorrichtung nach Anspruch 1, wobei der Führungsteiler n Elementarführungen (EWi) umfasst, um die n Elementarstrahlen (OBi) zu den zugehörigen Fotodioden fortzupflanzen.

3. Vorrichtung nach einem der vorhergehenden Ansprüche, wobei der Führungsteiler eine sternförmige Führung ist.

4. Vorrichtung nach Anspruch 1 oder 2, wobei der Führungsteiler eine Interferenzführung ist.

5. Vorrichtung nach einem der vorhergehenden Ansprüche, wobei die Länge der Antenne die Hälfte der Mittenwellenlänge beträgt.

6. Vorrichtung nach dem vorhergehenden Anspruch, wobei die Metallelemente eine Linienform bilden und die Antenne dann eine Antenne vom Quasi-Dipol-Typ ist.

7. Vorrichtung nach einem der Ansprüche 1 bis 5, wobei die Metallanordnung so konfiguriert ist, dass die Antenne vom logarithmisch-periodischen Typ ist.

8. Vorrichtung nach einem der vorhergehenden Ansprüche, wobei die Metallanordnung über eine an beide Enden angelegte Gleichspannung polarisiert ist.

9. Vorrichtung nach einem der vorhergehenden Ansprüche, wobei die Fotodioden in einer Matrix gemäß einer Vielzahl von parallelen Zeilen angeordnet sind, die an den Enden elektrisch miteinander verbunden sind.

10. Vorrichtung nach einem der Ansprüche 2 bis 9, umfassend ein Substrat (S), auf dem der Führungsteiler (SW) angeordnet ist, wobei jede Fotodiode eine aktive Schicht (AL) umfasst, die zwischen einer ersten (LN) und einer zweiten (LP) Kontaktschicht angeordnet ist und über die erste Kontaktschicht mit dem zugehörigen Elementarleiter gekoppelt ist, wobei ein Metallelement (Mele), das zwischen zwei aufeinanderfolgenden Dioden angeordnet ist, die erste Kontaktschicht (LNi) einer Fotodiode (PDi) mit der zweiten Kontaktschicht (LPi+1) der nächsten Fotodiode (PDi+1) elektrisch verbindet.

11. Vorrichtung nach Anspruch 10, wobei das Substrat aus InP besteht, der Führungsteiler GaInAs oder GaInAsP umfasst und die aktive Schicht GaInAs oder GaInAsP umfasst.


**Claims**

1. An optoelectronic device (10) for generating and radiating an electromagnetic signal (S) having at least one central frequency F0 between 30 GHz and 1 THz, comprising:

   - a dividing guide (SW) which is configured to divide in an XY plane an optical inlet beam (OB) which carries the electromagnetic signal (S) into n elementary beams (OBi),
   - a group of n photodiodes (PDi) which comprise a semi-conductor material and which are arranged in at least one row, the photodiodes of a row being electrically connected to each other in series by a planar metal assembly (ME) comprising a plurality of metal elements (Mele), a photodiode being connected to the following one by a metal element and being arranged between two metal elements,
   - the dividing guide (SW) further being configured to inject an elementary beam into an associated photodiode (PDi) and so that a relative optical delay between two elementary beams upon arrival at the associated photodiode is less than a period of the electromagnetic signal,
   - the metal assembly (ME) and the group of photodiodes forming an antenna (Ant) which is able to radiate the electromagnetic signal (S), each photodiode constituting an electrical input of the antenna, the antenna having a length (L0) equal to a multiple of half of a central wavelength (λ0) calculated based on the central frequency (F0).

2. The device according to claim 1, wherein the dividing guide comprises n elementary guides (EWi) for propagating the n elementary beams (OBi) to the associated photodiodes.

3. The device according to one of the preceding claims, wherein the dividing guide is a star-like guide.

4. The device according to claim 1 or 2, wherein the dividing guide is an interference guide.

5. The device according to any one of the preceding claims, wherein the length of the antenna is equal to half of the central wavelength.

6. The device according to the preceding claim, wherein the metal elements form a line, the antenna then being of the quasi di-pole type.

7. The device according to any one of claims 1 to 5, wherein the metal assembly is configured so that the antenna is of the log-periodic type.

8. The device according to any one of the preceding claims, wherein the metal assembly is polarised via a DC voltage which is applied at the two ends.

9. The device according to any one of the preceding claims, wherein the photodiodes are arranged in a matrix in accordance with a plurality of parallel lines which are electrically connected to each other by the ends.

10. The device according to any one of claims 2 to 9, comprising a substrate (S) on which the dividing guide (SW) is arranged, each photodiode comprising an active layer (AL) which is arranged between a first contact layer (LN) and a second contact layer (LP) and being coupled to the associated elementary guide via the first contact layer, a metal element (Mele) arranged between two successive diodes electrically connecting the first contact layer (LNi) of a photodiode (PDi) to the second contact layer (LPi+1) of the following photodiode (PDi+1).

11. The device according to claim 10, wherein the substrate is made of InP, the dividing guide comprises GaInAs or GaInAsP and the active layer comprises GaInAs or GaInAsP.

RFoutput

MAA

SubD    SubP

Opt

FIG.1

ML1

OBin    OW        PD

RFouput, Fo

ML2

$\ell = \dfrac{\lambda o}{2}$

FIG.2

FIG.3

FIG.4

EP 4 010 932 B1

FIG.5

FIG.6

FIG.7

FIG.8a

FIG.8c

FIG.8b

FIG.8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2014231627 A1

**Littérature non-brevet citée dans la description**

- **SHIMIZU et al.** Photodiode-Integrated Microstrip Antenna Array for Subterahertz Radiation. *IEEE Photonics technology letters,* 15 Mars 2006, vol. 18 (6